# DEMANDE DE BREVET EUROPEEN

(11) **EP 1 257 027 A1**
(43) Date de publication de la demande: **13.11.2002**
(21) Numéro de dépôt: 02354063.6
(22) Date de dépôt: 23.04.2002
(51) Int. Cl.: H01S 5/42, H01L 31/0232, H01L 31/0352

(54) **Dispositif optique comportant une pluralité de cavités résonantes de longuers différentes associées à différentes longuers d'ondes**

(30) Priorité: 25.04.2001 FR 0105571
(71) Demandeur: Commissariat à l'Energie Atomique, 38050 Grenoble (FR)
(72) Inventeur: Marion, Francois, 38120 Saint Egrève (FR)
(74) Mandataire: Hecke, G.

(57) **Abrégé**

Le dispositif comporte plusieurs cavités résonantes de longueurs différentes, de manière à émettre sur plusieurs longueurs d'onde différentes (λ1, λ2, λ3 ou λ4), dépendant de la longueur de la cavité correspondante. Chaque cavité résonante comporte une calotte convexe (6), de préférence hémisphérique, en matériau transparent pour les longueurs d'onde émises. La calotte convexe (6) définit, à une extrémité de la cavité, une surépaisseur, de longueur li, qui permet de faire varier la longueur (I+Ii) de la cavité correspondante. Les calottes sont, de préférence, obtenues par refonte de galettes de dimensions prédéterminées, par exemple en sélénium, sur le matériau constituant les cavités.

## Description

### Domaine technique de l'invention

L'invention concerne un dispositif optique comportant une pluralité de cavités résonantes de longueurs différentes associées à différentes longueurs d'onde.

### État de la technique

Un tel dispositif est, par exemple, destiné à constituer, sur une même puce optoélectronique; un réseau de lasers à multiples longueurs d'ondes, de type VCSEL (« vertical cavity surface emitting laser »), c'est-à-dire à cavité verticale émettant par la surface.

Dans l'art antérieur, la variation de la longueur des cavités résonantes d'un réseau de lasers de type VCSEL a été obtenue par divers procédés, notamment par gravures successives de hauteurs différentes (EP-A-949728), par déplacement micromécanique d'une membrane (brevet US 5771253) ou par contrôle de l'épaisseur de croissance épitaxiale de chaque cavité (EP-A-1030420).

Toutefois, ces techniques sont complexes, notamment parce qu'elles nécessitent une étape technologique particulière pour chaque longueur de cavité.

### Objet de l'invention

L'invention a pour but un dispositif ne présentant pas les inconvénients des dispositifs antérieurs.

Selon l'invention, ce but est atteint par le fait que chaque cavité résonante comporte une calotte convexe d'épaisseur prédéterminée, en matériau transparent pour lesdites longueurs d'onde, destinée à déterminer la longueur de la cavité résonante associée.

Selon un développement de l'invention, les calottes peuvent être obtenues par refonte de galettes sur le matériau constituant les cavités.

Les galettes ont, de préférence, des surfaces différentes, en fonction de l'épaisseur prédéterminée de la calotte correspondante.

### Description sommaire des dessins

D'autres avantages et caractéristiques ressortiront plus clairement de l'exposé qui va suivre de modes de réalisations particuliers de l'invention, donnés à titre d'exemples non limitatifs et représentés aux dessins annexés sur lesquels:
La figure 1 est une vue schématique d'un dispositif formant un réseau de lasers de type VECSEL selon l'art antérieur.
La figure 2 représente, sous forme schématique, un dispositif selon l'invention.
La figure 3 représente, à échelle plus agrandie, une des cavités résonantes du dispositif selon la figure 2.
Les figures 4 et 5 illustrent des variantes de réalisation d'un dispositif comportant des cavités résonantes selon la figure 3.
La figure 6 illustre un mode de réalisation particulier de calottes d'un dispositif selon l'invention, par refonte de galettes.
Les figures 7 et 8 illustrent schématiquement deux étapes successives d'un autre mode particulier de réalisation de calottes d'un dispositif selon l'invention, par gravure simultanée du matériau et d'une couche de résine.

### Description de différents modes de réalisation

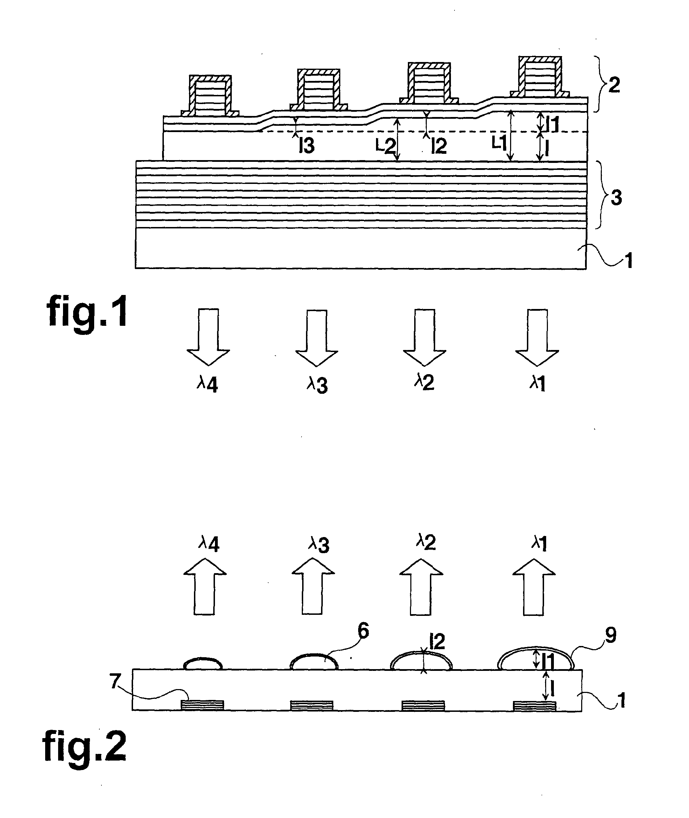

Un dispositif connu formant un réseau de lasers de type VECSEL est illustré sur la figure 1. Il comporte 4 cavités laser résonantes formées dans une même puce optoélectronique 1. Chaque cavité est classiquement délimitée par des premier et second miroirs 2 et 3, réalisés sous la forme de miroirs de Bragg distribués. La longueur L1, L2, L3 ou L4, de chaque cavité est définie par la somme d'une première longueur I, commune à toutes les cavités, et d'une seconde longueur I1, I2 I3 ou I4, différente pour chaque cavité. La variation de la seconde longueur est obtenue par contrôle de l'épaisseur de croissance épitaxiale de chaque cavité. Sur la figure 1, les secondes longueurs sont décroissantes de I1, à I4 et la longueur I4 est nulle. Chaque cavité émet à une longueur d'onde, respectivement λ1, λ2, λ3 ou λ4, dépendant de la longueur de la cavité.

Un mode particulier de réalisation d'un dispositif selon l'invention est représenté, sous forme schématique, à la figure 2. Il comporte, comme le dispositif de la figure 1, quatre cavités résonantes de longueurs différentes L1, L2, L3 ou L4, avec Li = l + li et i = 1 à 4, de manière à émettre sur quatre longueurs d'onde différentes λ1, λ2, λ3 ou λ4, dépendant de la longueur de la cavité correspondante.

Sur la figure 2, chaque cavité résonante comporte une calotte convexe 6, de préférence hémisphérique, en matériau transparent pour les longueurs d'onde émises. La calotte convexe 6 définit, à une extrémité de la cavité, une surépaisseur, correspondant à la longueur li, qui permet de faire varier la longueur Li de la cavité correspondante.

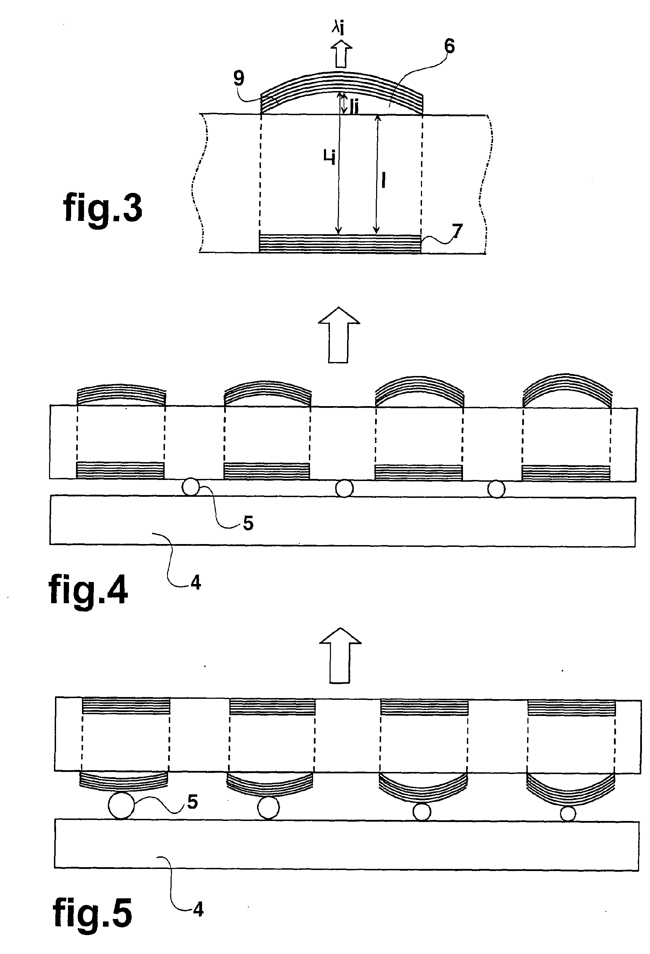

Une des cavités résonantes du dispositif selon la figure 2 est représentée, à échelle plus agrandie, sur la figure 3. La cavité résonante est délimitée, à sa partie inférieure, par un miroir de Bragg 7, de réflectivité R₁, et à sa partie supérieure par un autre miroir de Bragg 9, de réflectivité R₂. Une partie intermédiaire de la cavité laser résonante, de longueur I identique pour toutes les cavités du dispositif, est de type classique et située au-dessus du miroir de Bragg inférieur 7. Selon l'application envisagée, les miroirs 7 et 9 ne seront pas nécessairement des miroirs de Bragg. L'un des miroirs peut, par exemple, être de type métallique et sa réflectivité est alors pratiquement de 100%.

Une calotte convexe 6, en matériau transparent aux longueurs d'onde devant être émises par les cavités, est formée au-dessus de la partie intermédiaire de la cavité, constituant une surépaisseur correspondant à une longueur Iᵢ prédéterminée. La cavité a donc une longueur totale l + li. Le miroir 9 est formé sur la calotte 6. La réflectivité R₂ du miroir 9 étant, sur la figure 3, supposée inférieure à la réflectivité R₁ du miroir de Bragg 7, l'émission, à une longueur d'onde λi, se fait à partir de la partie supérieure de la cavité. Dans l'hypothèse inverse, c'est-à-dire si R₂ > R₁, l'émission se fera par la partie inférieure.

Pour faire fonctionner le réseau de cavités, ce dernier est connecté à un circuit électronique de commande 4 (figures 4 et 5), de type connu, auquel il est classiquement connecté par l'intermédiaire de billes de connexion 5, en matériau électriquement conducteur. D'autres réalisations sont aussi possibles comme, par exemple, une connexion par la face supérieure ou une juxtaposition, par report de couche mince (« epitaxial lift off » ELO), par collage conducteur anisotropique, etc...

La figure 4 correspond à une hybridation face arrière. L'émission devant alors se faire nécessairement par la face avant où se trouvent les calottes, il faudra avoir R₂ < R₁.

La figure 5 correspond à une hybridation face avant. L'émission se fera alors par la face arrière et il faudra avoir R₁ < R₂.

D'autre part, l'activation des cavités peut se faire classiquement par injection électrique ou par pompage.

Les calottes 6 peuvent être formées par tout moyen approprié.

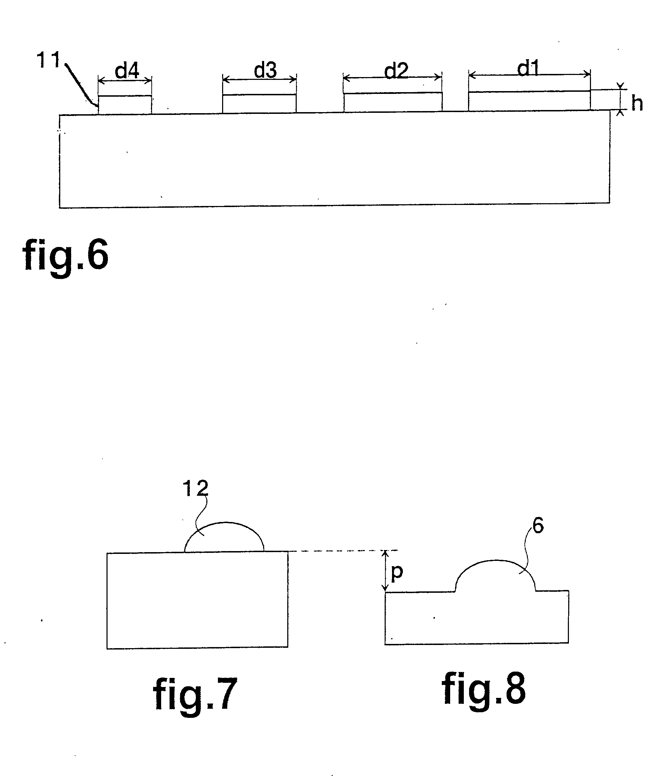

Dans le mode préférentiel de réalisation des calottes illustré à la figure 6, les calottes sont réalisées par refonte de galettes 11 préalablement déposées, par tout procédé approprié, sur le matériau constituant les cavités. Les galettes 11, et en conséquence les calottes 6, sont, de préférence, en sélénium, le matériau constituant les cavités étant, classiquement, en arséniure de gallium (AsGa), en phosphure d'indium (InP), en silicium (Si) ou en un de leurs dérivés. Le sélénium présente l'avantage d'être transparent aux longueurs d'onde utilisées et d'avoir un point de fusion, voisin de 200°C, compatible avec les technologies utilisées. De plus il adhère correctement sur toute la surface du support, notamment dans le cas d'un support en arséniure de gallium (AsGa). Aucun matériau opaque de mouillage ne s'interposant entre les deux matériaux, l'élément obtenu est transparent.

Chaque galette 11 a des dimensions prédéterminées, en fonction de l'épaisseur désirée de la calotte correspondante. Sur la figure 6, toutes les galettes 11, dont la base est de section circulaire, ont la même épaisseur h, mais des diamètres différents d1, d2, d3 ou d4. L'ensemble est ensuite porté à une température suffisante pour provoquer la fusion des galettes 11, qui prennent ainsi la forme de calottes hémisphériques 6. Grâce aux forces d'adhérence existant entre le matériau constituant la galette et son support, la base de la calotte ainsi formée est à l'image de la base de la galette correspondante. La géométrie d'une calotte (hauteur, rayon de courbure...) est parfaitement contrôlée et dépend uniquement du volume initial de la galette correspondante, c'est-à-dire du produit de la surface de base de la galette par son épaisseur h.

À titre d'exemple, les longueurs d'onde suivantes ont été obtenues avec des calottes formées à partir de galettes 11 en sélénium, de section circulaire et d'épaisseur constante h = 0,2µm :

| | | | | |
|---|---|---|---|---|
| Diamètre de la galette | 10µm | 12µm | 14µm | 18µm |
| Longueur d'onde | λ₀ | λ₀ + 0,5nm | λ₀ + 1nm | λ₀ + 1,5nm |

Les différences obtenues pour les épaisseurs des calottes sont suffisantes pour permettre une grande variabilité de la longueur d'onde d'émission d'une cavité résonante comportant de telles calottes.

La base des galettes n'est pas impérativement circulaire, mais peut avoir une forme quelconque, en fonction de la forme désirée pour les calottes. À titre d'exemple, la base des galettes peut également être carrée, rectangulaire ou ovale.

Par ailleurs, les galettes peuvent être réalisées aussi bien dans le même matériau que celui constituant les cavités que dans un matériau différent. Les matériaux sont choisis de manière à ce qu'une force d'adhérence existe au contact des galettes et de leur support au moment du dépôt des galettes ou après un recuit. À titre d'exemple, le matériau utilisé pour la formation des calottes peut être aussi, selon les variations de longueurs d'onde souhaitées, de l'As₂S₃ ou de l'As₂Se₃ pour des longueurs d'onde de l'ordre du micromètre, ou encore des verres pour des longueurs d'ondes de l'ordre du visible.

Après refonte des galettes 11 pour former les calottes 6, le dispositif est complété par dépôt des miroirs 9 sur les calottes. Les miroirs 9 sont, de préférence, des miroirs de type diélectrique. À titre d'exemple, les couches diélectriques peuvent être formées par les matériaux suivants : SiO, SiN, YF₃, ZnS, TiO₂... Les miroirs 9 peuvent aussi être de type semi-conducteur et être réalisés en GaAs, GaAlAs.

La disposition du miroir 9, concave, sur la calotte 6 augmente la convergence spectrale des longueurs d'onde à l'intérieur d'une cavité résonante, que l'émission ait lieu du côté des calottes (figure 4) ou du côté opposé (figure5).

II est de plus à noter que les calottes 6 jouent également le rôle de microlentilles lorsque le dispositif émet du côté des calottes (figure 4), provoquant une convergence spatiale des faisceaux lumineux de sortie.

En résumé, dans le mode de réalisation de la figure 4, l'obtention d'un dispositif de type VCSEL peut comporter les étapes successives suivantes :
a) Réalisation d'une puce optoélectronique 1 comportant, pour chaque cavité résonante, une zone active et un miroir de Bragg 7.
b) Hybridation de cette puce sur un circuit électronique de commande 4, notamment en silicium, lorsque la puce émet par la face opposée au miroir de Bragg.
c) Amincissement de la puce jusqu'à une épaisseur déterminée.
d) Dépôt de différentes galettes 11, par exemple en sélénium, d'un diamètre respectif prédéterminé en fonction des longueurs désirées des différentes cavités résonantes du dispositif.
e) Fusion des galettes 11 pour former des calottes 6 d'épaisseurs prédéterminées.
f) Dépôt d'un deuxième miroir de Bragg 9 sur chacune des calottes 6.

D'autres procédés de réalisation des calottes peuvent être envisagées, par exemple par gravure, chimique ou au plasma, de résine recuite, ou encore par fusion d'un matériau déposé sur une surface mouillable, ou par réalisation de structures non-planaires par dépôt de matériau dans des ouvertures.

Les figures 7 et 8 illustrent schématiquement deux étapes successives d'un autre mode particulier de réalisation de calottes d'un dispositif selon l'invention, par gravure simultanée du matériau et d'une couche de résine.

Selon ce type de procédé, déjà été utilisé dans l'art antérieur pour la fabrication de microlentilles, une couche de résine photosensible est déposée sur un matériau de base, par exemple en AsGa, et est ensuite fluée jusqu'à l'obtention d'une forme hémisphérique 12 de dimensions souhaitées. La figure 7 illustre cette étape de fabrication. La calotte 6 est ensuite réalisée dans le matériau de base, c'est-à-dire dans le matériau constituant la cavité, par gravure. La gravure est une gravure anisotrope simultanée du matériau de base et de la résine, à une profondeur p prédéterminée (figure 8) permettant d'éliminer totalement la couche de résine.

Contrairement au mode de réalisation des calottes par refonte de galettes (figure 6), la technique de gravure selon les figures 7 et 8 présente comme inconvénient l'impossibilité pour le matériau de base de recevoir des composants actifs à la surface comportant les calottes.

Dans certains cas, une difficulté peut apparaître lorsque l'écart de longueur d'onde demandé est faible, par exemple inférieur à 0,1nm. En effet, le contrôle de l'épaisseur de la galette initiale doit alors être très précis. Une solution consiste à utiliser la technique, connue, d'épitaxie par jet moléculaire (E.J.M.), qui permet de contrôler le dépôt de matériaux avec une précision inférieure à 1nm. Les étapes de fabrication peuvent, par exemple, être les suivantes :
- Par épitaxie par jet moléculaire (E.J.M.), dépôt du premier miroir sur un substrat, dépôt du matériau de la cavité, dépôt d'une couche d'arrêt et dépôt d'un matériau à bas point de fusion.
- Par photolithographie, réalisation de galettes de taille variable dans le matériau à bas point de fusion (arrêt de la gravure sur la couche d'arrêt).
- Refonte des galettes et formation des calottes de hauteur variable.
- Dépôt du deuxième miroir.

Bien que l'invention ait été décrite ci-dessus pour former un laser de type VCSEL, elle n'est pas limitée à ce type d'application. Elle peut, en effet, être utilisée dans un réseau d'émetteurs optiques constitués de diodes électroluminescentes. Elle peut aussi être utilisée dans un détecteur de rayonnement permettant la sélection de différentes longueurs d'onde. Dans un tel dispositif, la lumière entrant par les calottes 6 est amplifiée et détectée dans les différentes cavités résonantes, qui constituent des éléments sélecteurs de longueur d'onde.

## Revendications

1. Dispositif optique comportant une pluralité de cavités résonantes de longueurs différentes associées à différentes longueurs d'onde, **caractérisé en ce que** chaque cavité résonante comporte une calotte convexe (6) d'épaisseur (li) prédéterminée, en matériau transparent pour lesdites longueurs d'onde, destinée à déterminer la longueur (Li) de la cavité résonante associée.

2. Dispositif selon la revendication 1, **caractérisé en ce que** les calottes (6) sont hémisphériques.

3. Dispositif selon l'une des revendications 1 et 2, **caractérisé en ce que** les calottes (6) sont formées dans le même matériau que celui constituant les cavités.

4. Dispositif selon la revendication 3, **caractérisé en ce que** le matériau est de l'arséniure de gallium, du phosphure d'indium ou un de leurs dérivés.

5. Dispositif selon l'une des revendications 1 et 2, **caractérisé en ce que** les calottes (6) sont formées dans un matériau différent du matériau constituant les cavités.

6. Dispositif selon la revendication 5, **caractérisé en ce que** les calottes (6) sont en sélénium.

7. Dispositif selon l'une quelconque des revendications 1 à 6, **caractérisé en ce que** les calottes sont obtenues par refonte de galettes (11) sur le matériau constituant les cavités.

8. Dispositif selon la revendication 7, **caractérisé en ce que** les galettes (11) ont des surfaces différentes, en fonction de l'épaisseur (li) prédéterminée de la calotte (6) correspondante.

9. Dispositif selon l'une quelconque des revendications 1 à 8, **caractérisé en ce qu'**il comporte des miroirs (9) déposés sur les calottes (6).

10. Dispositif selon la revendication 9, **caractérisé en ce que** les miroirs (9) sont des miroirs diélectriques.

11. Dispositif selon la revendication 9, **caractérisé en ce que** les miroirs (9) sont des miroirs semi-conducteurs.

12. Dispositif selon l'une quelconque des revendications 1 à 11, **caractérisé en ce que** le dispositif forme un réseau de lasers de type VCSEL..

13. Dispositif selon l'une quelconque des revendications 1 à 11, **caractérisé en ce que** le dispositif forme un réseau d'émetteurs optiques.

14. Dispositif selon l'une quelconque des revendications 1 à 11, **caractérisé en ce que** le dispositif est un détecteur de rayonnement, permettant la sélection de différentes longueurs d'onde.
